(19) **Europäisches Patentamt / European Patent Office / Office européen des brevets**

(11) **EP 4 019 253 B1**

(12) **EUROPEAN PATENT SPECIFICATION**

(45) Date of publication and mention
of the grant of the patent:
**27.05.2026 Bulletin 2026/22**

(21) Application number: **20856748.7**

(22) Date of filing: **01.07.2020**

(51) International Patent Classification (IPC):
*G03F 7/027* (2006.01)    *G03F 7/031* (2006.01)
*G03F 7/033* (2006.01)    *G03F 7/09* (2006.01)
*G03F 7/20* (2006.01)    *B41C 1/00* (2006.01)
*B41N 1/12* (2006.01)    *B41M 1/04* (2006.01)

(52) Cooperative Patent Classification (CPC):
**G03F 7/033; B41N 1/12; G03F 7/027; G03F 7/031;
G03F 7/092; G03F 7/202**

(86) International application number:
**PCT/JP2020/025897**

(87) International publication number:
**WO 2021/039107 (04.03.2021 Gazette 2021/09)**

(54) **FLEXOGRAPHIC PRINTING PLATE**

FLEXODRUCKPLATTE

PLAQUE D'IMPRESSION FLEXOGRAPHIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.08.2019 JP 2019152851**

(43) Date of publication of application:
**29.06.2022 Bulletin 2022/26**

(73) Proprietor: **TOYOBO MC Corporation
Osaka-shi, Osaka 530-0001 (JP)**

(72) Inventors:
• **YOSHIMOTO, Kazuya
Okayama-shi, Okayama 704-8194 (JP)**
• **HIGO, Eri
Otsu-shi, Shiga 520-0292 (JP)**

• **NAKAMORI, Masahiko
Okayama-shi, Okayama 704-8194 (JP)**

(74) Representative: **Müller-Boré & Partner
Patentanwälte PartG mbB
Friedenheimer Brücke 21
80639 München (DE)**

(56) References cited:
WO-A1-2016/174948    WO-A1-2016/174948
GB-A- 2 064 151    JP-A- 2001 005 173
JP-A- 2001 005 173    JP-A- 2002 062 639
JP-A- 2017 154 301    JP-A- 2018 091 953
JP-A- 2018 091 953    JP-A- 2019 095 470
JP-A- 2019 095 470    US-A1- 2004 259 034
US-A1- 2011 219 973    US-A1- 2019 061 406

# EP 4 019 253 B1

**Description**

Technical Field

The present invention relates to a flexographic printing plate which is excellent in a printability of fine dots in a fade-out part, and to a flexographic printing method using the flexographic printing plate.

Background Art

Flexographic printing is a printing method in which an ink is applied onto convex parts on a printing plate and then the printing plate is pressed against a substrate so as to transfer the ink from the printing plate to the substrate. A printing plate used in flexographic printing is relatively soft and can fit to various shapes, and therefore makes it possible to print on wide varieties of substrates. Examples of the substrate include a packaging film, label paper, drink carton, a paper-made container, an envelope and cardboard. Particularly for a substrate having a rough surface, flexographic printing is mainly employed. Furthermore, flexographic printing can utilize a water-based or alcohol-based ink from which the emission amount of VOCs (volatile organic compounds) is small. Therefore, flexographic printing is a highly environment-friendly printing method. Due to the above-mentioned advantages, i.e., the adaptability to substrates and the environmental friendliness, gravure printing and offset printing are increasingly shifting to flexographic printing.

In flexographic printing, however, a relatively soft printing plate is pressed against a substrate for printing. Therefore, the printing plate is deformed upon the pressing and the phenomenon (dot gain) that the size of each printed dot becomes larger than the size of each dot on the printing plate occurs. The dot gain is apt to occur particularly in a part in which the dot gradation shifts to zero (i.e., a fade-out part). The excessive print growth in this part is contrasted with a part having a gradation of zero and therefore is very noticeable. As a result, the print quality is greatly deteriorated.

Heretofore, as to a method for reducing dot gain, a method in which the dynamic hardness of dots is increased has been proposed (see Patent Document 1). In Patent Document 1, a polyfunctional crosslinkable monomer is added to a photosensitive resin layer so as to increase the crosslinking density, thereby improving the dynamic hardness of the dots. In this printing plate, although the dot gain in a center part of the image can be reduced, the excessive dot growth in a fade-out part cannot be prevented.

In order to prevent the excessive print growth in the fade-out part, it has been proposed to previously adjust the height of a dot top in an edge part to a value smaller than the height of a dot top in a center part (Patent Document 2). However, this method can be achieved only by a laser engraving plate making method, and cannot be employed in a printing plate making process which employs a conventional exposure procedure and a conventional development procedure. In addition, the laser engraving method has disadvantages that a device to be used is expensive and the production speed is unsatisfactory.

On the other hand, an example of a common flexographic printing plate is disclosed in Patent Document 3. A photosensitive resin layer in a flexographic printing plate disclosed in Patent Document 3 is characterized by including (A) a hydrophobic polymer obtained from a water-dispersible latex, (B) a hydrophilic polymer, (C) a photopolymerizable unsaturated compound, and (D) a photopolymerization initiator, in which (C-1) a photopolymerizable oligomer containing no hydroxyl group, (C-2) a photopolymerizable monomer containing a hydroxyl group and (C-3) a photopolymerizable monomer containing no hydroxyl group are used as the photopolymerizable unsaturated compound (C). In the flexographic printing plates produced in Examples in Patent Document 3, the undersupply of an ink in printing and printing durability are improved. However, these printing plates cannot achieve printability in a fade-out part.

For these reasons, a flexographic printing plate which enables the reduction of dot gain of fine dots in a fade-out part has been still keenly demanded.

Patent Document 4 discloses a water-developable photosensitive flexographic printing plate.

Patent Document 5 discloses a photosensitive CTP letterpress printing original plate.

Patent Document 6 discloses a flexographic printing original plate.

Patent Document 7 discloses a flexographic printing plate.

Patent Document 8 discloses a relief printing original plate for rotary letterpress printing.

Patent Document 9 discloses the production of flexographic printing plates by thermal development.

Prior Art Documents

Patent Documents

Patent Document 1: JP H09 80743 A

## EP 4 019 253 B1

Patent Document 2: JP 6395920 B2
Patent Document 3: JP 6079625 B2
Patent Document 4: JP 2001 005173 A
Patent Document 5: JP 2019 095470 A
Patent Document 6: JP 2018 091953 A
Patent Document 7: WO 2016/174948 A1
Patent Document 8: US 2019/061406 A1
Patent Document 9: US 2004/259034 A1

Disclosure of the Invention

Problem that the Invention is to Solve

The present invention has been made in these situations of the prior art techniques. The object of the present invention is to provide a flexographic printing plate in which the dot gain of fine dots in a fade-out part is reduced and printability is improved.

Means for Solving the Problem

The present inventors have made extensive and intensive studies for achieving the above-mentioned object. As a result, it was found as follows. In a conventional printing plate, dots formed thereon are soft, the shoulder angle of each dot is small, and the dot depth of each dot is large. Therefore, the shape of each dot is apt to lean (buckle) even with a small load. As a result, when a conventional printing plate is used for printing, the dots are enlarged during the printing and thus the reproducibility of an image becomes poor. It was also found that, by controlling the shape and the hardness of fine dots formed on a printing plate in such a manner that the fine dots do not buckle even when the fine dots undergo a specific high load, the dot gain of the fine dots can be reduced not only in a center part of an image but also in a fade-out part of the image. More specifically, it was found that, by controlling the shape of fine dots which is defined by a shoulder angle and a dot depth of each fine dot to a value within a specified range and by controlling the hardness of the fine dots to a value within a specified range, the effect to reduce the dot gain of the fine dots can be improved.

Then, it was found that the shape and hardness of the dots can be effectively controlled by the following countermeasures: a photopolymerization initiator is added in a larger amount compared with the conventional flexographic printing plate, in a photosensitive resin composition constituting a photosensitive resin layer; an ethylenically unsaturated compound having a low molecular weight is added in a specified amount as an ethylenically unsaturated compound component in the photosensitive resin composition, and the ratio of the mass of the photopolymerization initiator to the mass of the ethylenically unsaturated compound having a low molecular weight is adjusted to a higher value compared with the conventional flexographic printing plate; as to the ethylenically unsaturated compound component in the photosensitive resin composition, an ethylenically unsaturated compound having a high molecular weight is added in addition to the ethylenically unsaturated compound having a low molecular weight; as to a photopolymerization initiator component, specific two types of photopolymerization initiators are used; and an oxygen barrier layer is provided between the photosensitive resin layer and a mask layer. Based on these findings, the present invention which is as defined in the appended claims has been accomplished.

The present invention provides a flexographic printing plate obtained from a flexographic printing plate precursor comprising at least a support (A), a photosensitive resin layer (B) and a heat-sensitive mask layer (C) which are laminated in this order, characterized in that, when dots each having a diameter of 16 $\mu$m are formed at 175 lines per 2.54 cm (lpi) on the printing plate, the dots do not buckle until a load of 0.2 N is applied thereto, as measured in accordance with the method set out herein,

wherein a photosensitive resin composition constituting the photosensitive resin layer (B) comprises (a) a polymer prepared by polymerizing a conjugated diene, (b) an ethylenically unsaturated compound and (c) a photopolymerization initiator, and wherein the content of the photopolymerization initiator (c) in the photosensitive resin composition is 2 to 9% by mass based on the total mass of the photosensitive resin composition,
wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass based on the total mass of the photosensitive resin composition, and wherein the ratio of the mass of the photopolymerization initiator (c) and the mass of the (meth)acrylate compound (i) having a number average molecular weight of 100 to 600 in the photosensitive resin composition is within the range of 0.20 to 0.55,
wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass based on the total mass of the photosensitive resin composition, and

wherein the photopolymerization initiator (c) includes two types of compounds which are a benzyl alkyl ketal compound and a benzophenone compound, and wherein the ratio of the mass of the benzyl alkyl ketal compound to the mass of the benzophenone compound is within the range of 99:1 to 80:20.

Advantages of the Invention

The flexographic printing plate according to the present invention is configured such that, when specific fine dots are formed on the printing plate, the fine dots do not buckle until a specific high load is applied thereto. Therefore, the dot gain of the fine dots can be reduced not only in a center part of an image but also in a fade-out part of the image, resulting in the improvement in printing quality of the fine dots in the fade-out part.

Brief Description of the Drawings

FIG. 1 shows a schematic illustration of a longitudinal cross-section of a dot which explains a shoulder angle of the dot.
FIG. 2 shows graphs for calculating a buckling load of each of Example 2 and Comparative Example 1.

Best Mode for Carrying Out the Invention

The flexographic printing plate according to the present invention is a flexographic printing plate obtained from a flexographic printing plate precursor comprising at least a support (A), a photosensitive resin layer (B) and a heat-sensitive mask layer (C) which are laminated in this order. Specifically, the flexographic printing plate according to the present invention is a printing plate obtained by exposing and developing such a flexographic printing plate precursor. The flexographic printing plate according to the present invention is configured such that, when specific fine dots are formed on the printing plate, the fine dots do not buckle until a specific high load is applied thereto. By constituting the fine dots formed on a printing plate in such a way that the fine dots do not buckle easily even when a specific load is applied thereto, the dot gain of the fine dots (which occurs by the action of a pressing pressure applied to the fine dots during printing wherein a printing plate is pressed against a substrate) can be prevented effectively not only in a center part of an image but also in a fade-out part in the image.

The (A) support used in flexographic printing plate precursor is preferably made from a material being flexible and having a superior dimension stability. Examples thereof include: a support made of metal, such as steel, aluminum, copper and nickel, and a support made of a thermoplastic resin, such as a polyethylene terephthalate film, a polyethylene naphthalate film, a polybutylene terephthalate film and a polycarbonate film. Among these, the polyethylene terephthalate film, which has the superior dimension stability and a sufficiently high viscoelasticity, is in particular preferably used. A thickness of the support is set to 50 to 350 $\mu$m, preferably, to 100 to 250 $\mu$m, from viewpoints of mechanical properties, shape stability and handling characteristics during manufacturing of a printing plate. Moreover, if necessary, an adhesive may be arranged between the support (A) and the photosensitive resin layer (B) in order to improve an adhesive property between them.

The photosensitive resin composition constituting the photosensitive resin layer (B) used in flexographic printing plate precursor comprises (a) a polymer prepared by polymerizing a conjugated diene, (b) an ethylenically unsaturated compound and (c) a photopolymerization initiator, and if necessary, comprises an additive such as a plasticizer, a hydrophilic compound, an ultraviolet ray absorber, a surface tension modulator, a thermal polymerization inhibitor, a dye, a pigment, a flavoring agent, and an antioxidant agent. The present invention is particularly characterized in that: in the photosensitive resin composition constituting the photosensitive resin layer (B), the composition of the ethylenically unsaturated compound (b) is specifically designed; and the photopolymerization initiator (c) is used at a mass-based ratio that is larger than the ratio actually employed in the conventional techniques.

As to the polymer prepared by polymerizing the conjugated diene (a), a conventional known synthetic high-molecular-weight compound that has been used in a printing plate precursor can be used. Examples of the polymer include a polymer prepared by polymerizing a conjugated diene hydrocarbon and a copolymer prepared by copolymerizing a conjugated diene hydrocarbon and a monoolefin unsaturated compound. Specific examples of the polymer include a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrene-chloroprene copolymer, an acrylonitrile-butadiene copolymer, an acrylonitrile-isoprene copolymer, a (methyl methacrylate)-butadiene copolymer, a (methyl methacrylate)-isoprene copolymer, an acrylonitrile-butadiene-styrene copolymer, and an acrylonitrile-isoprene-styrene copolymer. Among these polymers, a butadiene polymer is preferably used, from the viewpoint of the properties of flexographic printing plates, i.e., repulsion elasticity of a surface of a printing plate, high elongation properties, resin plate hardness, dimensional stability during unexposed state, and easy availability. These polymers may be used singly, or two or more of them may be used in combination. It is preferred that the content of the component (a) in the photosensitive resin composition that forms the photosensitive resin layer (B) is within the range of 40 to 70% by mass.

The ethylenically unsaturated compound (b) includes a (meth)acrylate compound having a number average molecular weight of 100 to 600 (hereinafter, it may be simply referred to as a (meth)acrylate compound having a low molecular weight) (i). In addition, the ethylenically unsaturated compound (b) further includes a (meth)acrylate compound having a number average molecular weight of more than 600 and not more than 20,000 (hereinafter, it may be simply referred to as a (meth)acrylate compound having a high molecular weight) (ii). The (meth)acrylate compound having a low molecular weight is crosslinked and cured by the action of a photopolymerization initiator so as to form a dense crosslinked network. The (meth)acrylate compound having a high molecular weight is crosslinked and cured by the action of the photopolymerization initiator so as to form a loose crosslinked network. The number average molecular weight of the former is preferably 200 to 500, and that of the latter is preferably 2000 to 10000. As mentioned above, when not only the (meth)acrylate compound having a low molecular weight but also the (meth)acrylate compound having a high molecular weight are contained, the reproducibility of isolated dots and durability during printing cannot be deteriorated even when the photopolymerization initiator (c) is added in a larger amount compared with the conventional flexographic printing plate. This is supposed to be because the toughness of the printing plate is increased by the addition of the (meth)acrylate compound having a high molecular weight in a specified amount. It is preferred that the content of the component (b) in the photosensitive resin composition that forms the photosensitive resin layer (B) is within the range of 10 to 50% by mass based on the total mass of the photosensitive resin composition.

The content of the (meth)acrylate compound having a high molecular weight in the photosensitive resin composition is 5 to 25% by mass and preferably 8 to 20% by mass based on the total mass of the photosensitive resin composition. If the content is less than the above-mentioned range, the durability may be deteriorated when the photopolymerization initiator (c) is added in a larger amount. If the content is more than the above-mentioned range, the composite elastic modulus of a solid-printed part may be increased, whereby the ink laydown on a solid-printed part may become insufficient, which may result in a poor quality of printed matters. The content of the (meth) acrylate compound having a low molecular weight in the photosensitive resin composition is 5 to 16% by mass and preferably 7 to 13% by mass based on the total mass of the photosensitive resin composition. When the content of the (meth)acrylate compound having a low molecular weight is less than the above-mentioned range, the effect to improve the composite elastic modulus of the dots may be insufficient, whereby the fine dots may easily buckle even when a low load is applied thereto. When the content is more than the above-mentioned range, the composite elastic modulus of the solid-printed part may be increased, whereby the ink laydown on a solid-printed part may become insufficient, which may result in a poor quality of printed matters.

The (meth)acrylate compound having a low molecular weight is not particularly limited, as long as the number average molecular weight of the compound is within the range of 100 to 600 inclusive. Examples of the compound include liner, branched or cyclic monofunctional monomers such as hexyl (meth)acrylate, nonane (meth)acrylate, lauryl (meth) acrylate, stearyl (meth)acrylate, 2-ethyl, 2-butylpropanediol (meth)acrylate, hydroxyethyl (meth)acrylate, 2-(meth)acryloyloxyethyl hexahydrophtalate, 2-(meth)acryloyloxyethyl phtalate, a (meth)acrylic acid dimer, ECH denatured allyl acrylate, benzyl acrylate, caprolactone (meth)acrylate, dicyclopentenyl (meth)acrylate, isobornyl (meth)acrylate and cyclohexyl (meth)acrylate. The examples also include linear branched or cyclic polyfunctional monomers such as hexanediol di(meth)acrylate, nonanediol di(meth)acrylate, 2-butyl-2-ethylpropanediol di(meth)acrylate, neopentyl glycol di(meth)acrylate, neopentylglycol hydroxypivalate di(meth)acrylate, ECH denatured phthalic acid di(meth)acrylate, dicyclopentadiene di(meth)acrylate, tricyclodecanedimethanol di(meth)acrylate, trimethylolpropane tri(meth)acrylate, pentaerythritol tri(meth)acrylate, ECH denatured glycerol tri(meth)acrylate, trimethylolpropane benzoate (meth)acrylate, EO(PO) denatured trimethylolpropane tri(meth)acrylate and dipentaerythritol hexa(meth)acrylate. These compounds may be used singly. Alternatively, two or more of them may be used in combination for the purpose of imparting a desired resin property.

The (meth)acrylate compound having a high molecular weight is not particularly limited, as long as the number average molecular weight of the compound is within the range of more than 600 and not more than 20,000. For example, a butadiene oligomer or an isoprene oligomer each having a (meth)acrylate group attached thereto, and urethane(meth) acrylate are also exemplified. These compounds may be used singly. Alternatively, two or more of them may be used in combination for the purpose of imparting a desired resin property.

The ratio of the mass of the photopolymerization initiator (c) and the mass of the (meth)acrylate compound (i) having a low molecular weight [(mass of the photopolymerization initiator)/(mass of the (meth)acrylate compound having a low molecular weight)] is 0.20 to 0.55. It is preferably 0.22 to 0.50 and more preferably 0.25 to 0.45. By employing such a ratio, the shoulder angle, the dot depth, and the dot composite elastic modulus of the fine dots can be fully satisfied. If the ratio is less than the above-mentioned range, the amount of the photopolymerization initiator is too small, and therefore the crosslinking reaction does not proceed with a small amount of light (i.e., scattering light in the photosensitive resin layer). As a result, the shoulder angle of each fine dot becomes small, and the dot depth of each fine dot becomes large, and therefore the shape of each fine dot becomes unstable, and the dot composite elastic modulus also becomes small. Consequently, the buckling load applicable to the fine dots on the printing plate may be decreased. If the ratio is more than the above-mentioned range, the amount of the photopolymerization initiator is too large relative to the amount of the (meth) acrylate and therefore the effect caused as the result of the increase in the amount of the photopolymerization initiator cannot be achieved.

Examples of the photopolymerization initiator (c) include a benzophenone compound, a benzoin compound, an acetophenone compound, a benzyl compound, a benzoin alkyl ether compound, a benzyl alkyl ketal compound, an anthraquinone compound and a thioxanthone compound. More specific examples include benzophenone, chlorobenzophenone, benzoin, acetophenone, benzyl, benzoin methyl ether, benzoin ethyl ether, benzoin isopropyl ether, benzoin isobutyl ether, benzyl dimethylketal, benzyl diethylketal, benzyl diisopropylketal, anthraquinone, 2-ethylanthraquinone, 2-methylanthraquinone, 2-allylanthraquinone, 2-chloroanthraquinone, thioxanthone and 2-chlorothioxanthone.

The photopolymerization initiator (c) includes two types of compounds which are a benzyl alkyl ketal compound and a benzophenone compound. The ratio of the mass of the benzyl alkyl ketal compound to the mass of the benzophenone compound is within the range of 99:1 to 80:20 and preferably within the range of 97:3 to 85:15. The photopolymerization initiator has an intrinsic optical absorption spectrum. Therefore, by using two types of photopolymerization initiators in combination, it becomes possible to efficiently utilize the optical energy of the below-mentioned finishing exposure and the exposure using a germicidal lamp. Particularly, when two types of photopolymerization initiators are a benzyl alkyl ketal compound and a benzophenone compound, the composite elastic modulus of each dot can be further improved. As a result, the buckling load applicable to the fine dots on the printing plate can be increased. As to the benzyl alkyl ketal compound, benzyl dimethylketal is preferred. As to the benzophenone compound, benzophenone is preferred. Particularly, benzophenone does not have optical absorption to a lamp to be used in the main exposure (peak wavelength: 370 nm), but has optical absorption to a lamp of a germicidal lamp (peak wavelength: 250 nm). Therefore, when benzophenone is used, any excess crosslinking reaction does not occur with the main exposure light, and the composite elastic modulus of each dot can be improved only by the exposure with a germicidal lamp. As a result, the buckling load applicable to the fine dots on the printing plate can be increased.

In the present invention, the content of the photopolymerization initiator (c) in the photosensitive resin composition is 2 to 9% by mass, preferably 2.5 to 7.5% by mass, and more preferably 3 to 7% by mass based on the total mass of the photosensitive resin composition. As mentioned above, the increase in the content of the photopolymerization initiator to a larger amount compared with the conventional flexographic printing plate can contribute to proceedings of the crosslinking reaction even with a small amount of light (i.e., scattering light in the photosensitive resin layer). Therefore, fine dots each having a stable shape having a large shoulder angle and a small dot depth are formed, and the dot composite elastic modulus of the fine dots is increased. As a result, the fine dots do not buckle until a specific high load is applied thereto. Conventionally, it has been believed that, when the content of a photopolymerization initiator is increased, the reach of light in the thickness direction of a printing plate is blocked due to the absorption of light by the photopolymerization initiator after the reaction to thereby deteriorate the reproducibility of isolated dots which is greatly affected by the crosslinking in the thickness direction and deteriorate the durability during printing. For these reasons, conventionally, the content of a photopolymerization initiator in a photosensitive resin composition of about 1% by mass at most has been generally employed in the actual practice. In contrast, in the present invention, by adding a (meth)acrylate compound having a high molecular weight in a specified amount in the photosensitive resin composition, it becomes possible to increase the toughness of a printing plate and to thereby overcome the above-mentioned disadvantages of prior arts (deterioration of reproducibility of isolated dots and deterioration of durability during printing) which occur when a photopolymerization initiator is used in a large amount, and therefore utilize benefit (formation of fine dots having a stable shape and increase of the buckling load of the fine dots due to the improvement in the composite elastic modulus of the dots, and as a result, improvement in the printability due to the decrease in dot gain of the fine dots in a fade-out part) from the increase in the content of the photopolymerization initiator.

The photosensitive resin composition constituting the photosensitive resin layer (B) used in flexographic printing plate precursor comprises, in addition to (a) a polymer prepared by polymerizing a conjugated diene, (b) an ethylenically unsaturated compound and (c) a photopolymerization initiator, an additive such as a plasticizer, a hydrophilic compound, an ultraviolet ray absorber, a surface tension modulator, a thermal polymerization inhibitor, a dye, a pigment, a flavoring agent, and an antioxidant agent, depending on necessity.

The plasticizer is used for imparting flexibility to the photosensitive resin layer (B). Examples of the plasticizer include a liquid rubber, an oil, a polyester, and a phosphorus-based compound. Examples of the liquid rubber include liquid polybutadiene, liquid polyisoprene, and a compound prepared by adding a hydroxyl group or a carboxyl group to each of these compounds. Examples of the oil include paraffin, naphthene and an aroma oil. An example of the polyester is an adipic acid-based polyester. An example of the phosphoric acid-based compound is a phosphoric acid ester. Among these compounds, a liquid polybutadiene and a liquid polybutadiene having a hydroxyl group or a carboxyl group attached thereto are preferred from the viewpoint of compatibility with the polymer prepared by polymerizing a conjugated diene. When the development is performed with a water-based developing solution, a liquid polybutadiene having a hydroxyl group or a carboxyl group attached thereto is particularly preferred. The content of the plasticizer in the photosensitive resin composition is preferably 5 to 15% by mass.

The hydrophilic compound is used for improving the developability of the photosensitive resin layer (B) with the water-based developing solution. Examples of the hydrophilic compound include a carboxylic acid, a carboxylic acid salt, a sulfonic acid, a sulfonic acid salt, an acrylic polymer having a hydrophilic group (e.g., a hydroxyl group, an amino group, a phosphate group, an ethylene oxide group, a propylene oxide group), a urethane polymer, a polyamide polymer, and a polyester polymer. In addition, a known surfactant may also be used. Among these compounds, a urethane polymer having a carboxylate group is preferred from the viewpoint of the developability in a water-based developing solution. The content of the hydrophilic compound in the photosensitive resin composition is preferably 1 to 15% by mass.

The surface tension modifier is used for modifying the surface tension of a printing plate. By modifying the surface tension of a printing plate, the ink transfer properties and the clogging with an ink on a printing plate can be modified. Examples of the surface tension modifier include a paraffin oil, a long-chain alkyl compound, a surfactant, a fatty acid amide, a silicone oil, a modified silicone oil, a fluorine compound, and a modified fluorine compound. The content of the surface tension modifier in the photosensitive resin composition is preferably 0.1 to 2% by mass.

The ultraviolet ray absorber is used for improving the exposure latitude of the photosensitive resin layer (B). Examples of the ultraviolet ray absorber include a benzophenone-based compound, a salicylate-based compound, a benzotriazole-based compound, an acrylonitrile-based compound, a metal complex salt-based compound, a hindered amine-based compound, an anthraquinone-based compound, an azo-based compound, a coumarin-based compound, and a furan-based compound. Among these compounds, a benzotriazole-based compound is preferred from the viewpoint of easy availability and exposure latitude. The content of the ultraviolet ray absorber in the photosensitive resin composition is preferably 0.005 to 0.1% by mass.

In general, when a flexographic printing plate is produced from a flexographic printing plate precursor, four types of exposure, i.e., back exposure, main exposure, finishing exposure and the exposure with a germicidal lamp, are performed. Back exposure is performed for irradiating the whole area with light from the support side so as to form a floor part on the printing plate. Main exposure is performed for imagewise-irradiating a flexographic printing plate precursor with light through a mask and then crosslinking and curing an unsaturated compound in a light-irradiated part on the photosensitive resin layer, thereby forming an area that will become an image. Finishing exposure is performed for irradiating, with light, the whole area of the printing plate which has been developed after the main exposure and now has convex parts that correspond to the dot part and solid-printed parts formed thereon. The role of finishing exposure is to compensate the insufficient crosslinking and curing by the main exposure and to crosslink and cure side surfaces of the convex of the dot part. Exposure with a germicidal lamp is performed for removing the surface stickiness of the printing plate, and partially has a role of crosslinking and curing of side surfaces of the convex of the dot part, similar to the finishing exposure. In general, each of main exposure and finishing exposure is performed utilizing UVA, while exposure with a germicidal lamp is performed utilizing UVC.

The curing of side surfaces of dots by the finishing exposure and the exposure with a germicidal lamp has occurred to some extent in the conventional flexographic printing plate. The finishing exposure and the exposure with a germicidal lamp are generally performed under atmosphere. Therefore, polymerization is inhibited by the action of oxygen in the atmosphere. Therefore, in the conventional flexographic printing plate, the level of the curing of side surfaces of dots by the finishing exposure and the exposure with a germicidal lamp is not so high. In the present invention, in contrast, the influence of the polymerization inhibition by oxygen can be reduced satisfactorily and the side surfaces of dots can be cured sufficiently by adding the photopolymerization initiator in a larger amount compared with the conventional flexographic printing plate. As a result, the composite elastic modulus of dots can be improved significantly, whereby the buckling load of the fine dots can be increased. By sufficiently curing the side surfaces of dots, it is supposed that the deformation of the dots can be suppressed.

If the content of the photopolymerization initiator is less than the above-mentioned preferred range, the hardness of the dots after finishing exposure and exposure with a germicidal lamp may become insufficient, and the shape of each fine dot may not satisfy the ranges of the shoulder angle and the depth as defined in the present invention, the fine dots may buckle easily at a lower load that is defined in the present invention, and dot gain of the fine dots may occur in a fade-out part. On the other hand, if the content of the photopolymerization initiator is more than the above-mentioned preferred range, the reproducibility of isolated dots and the durability of the printing plate may be deteriorated.

As to the heat-sensitive mask layer (C) used in the flexographic printing plate precursor, any conventional one which has been used in a printing plate precursor can be used. For example, the heat-sensitive mask layer is preferably composed of carbon black (which is a material having the function to absorb infrared ray laser so as to convert the absorbed infrared ray laser to heat and the function to block ultraviolet ray), a dispersion binder for carbon black, and a binder polymer capable of forming a coating film. The dispersion binder may double with the binder polymer capable of forming a coating film. Furthermore, an auxiliary component other than the above-mentioned components, e.g., a pigment dispersing agent, a filler, a surfactant and a coating aid, may be contained, as long as the effects of the present invention cannot be deteriorated.

The heat-sensitive mask layer (C) used in the flexographic printing plate precursor for obtaining the flexographic printing plate of the present invention is preferably developable with water. Examples of the heat-sensitive mask layer (C) include: a heat-sensitive mask layer containing a combination of a polyamide containing a polar group and a butyral resin (JP 4200510 B2); a heat-sensitive mask layer containing a polymer having the same structure as that of the polymer in the photosensitive resin layer and an acrylic resin (JP 5710961 B2); and a heat-sensitive mask layer containing an anionic polymer and a polymer having an ester group in a side chain thereof and having a saponification degree of 0 to 90% inclusive (JP 5525074 B2).

Preferably, the flexographic printing plate precursor for obtaining the flexographic printing plate of the present invention is provided with an oxygen barrier layer (D) between the photosensitive resin layer (B) and the heat-sensitive mask layer (C). When an oxygen barrier layer (D) is provided, the oxygen-induced polymerization inhibition during main exposure can be inhibited, and a satisfactory curing reaction can occur. As a result, fine dots each having a stable shape having a large shoulder angle and a small dot depth can be formed, and the fine dots may not buckle until a specific high load is applied thereto. Examples of the binder polymer in the barrier layer include polyvinyl alcohol, partially saponified polyvinyl acetate, an alkyl cellulose, a cellulose-based polymer, and polyamide. These polymers may not be always used singly, or a combination of two or more of these polymers may be used. Examples of the binder polymer which are preferred from the viewpoint of oxygen barrier performance include polyvinyl alcohol, partially saponified polyvinyl acetate, and polyamide. By selecting a binder polymer having oxygen barrier performance within a preferred range, it is possible to control the image reproducibility appropriately.

The thickness of the barrier layer is preferably 0.2 to 3.0 $\mu$m and further preferably 0.2 to 1.5 $\mu$m. If the thickness is smaller than the above-mentioned range, the oxygen barrier performance may become insufficient and the printing surface of a relief may be roughened. If the thickness is more than the above-mentioned range, the deterioration in reproducibility of a fine line may occur.

Although a method for producing the flexographic printing plate precursor for obtaining the flexographic printing plate of the present invention is not particularly limited, it may be produced generally as mentioned below.

Firstly, components of heat-sensitive mask layer (C) such as binder other than the carbon black are dissolved in a suitable solvent, and then the carbon black is dispersed therein so as to prepare a dispersion. Then the dispersion is applied onto a support for the heat-sensitive mask layer (such as a polyethylene terephthalate film). Then the solvent is evaporated therefrom. After that, a component for the oxygen barrier layer (D) is applied thereon whereupon one laminate is prepared. Further, apart therefrom, the photosensitive resin layer (B) is formed on another support (A) by means of application whereupon another laminate is prepared. The prepared two laminates are layered under pressurization and/or heating in such a manner that the photosensitive resin layer (B) adjacently contacts the oxygen barrier layer (D). Incidentally, after completion of the printing plate precursor, the support for the heat-sensitive mask layer functions as a protective film for a surface thereof.

Now, a method for producing a flexographic printing plate from this flexographic printing plate precursor produced as mentioned above will be explained. Firstly, the protective film (if any) is removed from the flexographic printing plate precursor. Thereafter, the heat-sensitive mask layer (C) is imagewise-irradiated with an IR laser so that a mask is formed on the photosensitive resin layer (B). Preferable examples of the IR laser include an ND/YAG laser (1064 nm) and a diode laser (for example, 830 nm). A laser system suitable for the Computer to Plate Technique is commercially available, and, for example, CDI (manufactured by Esko-Graphics Co., Ltd.) may be used. This laser system includes a rotation cylinder drum used for holding a printing plate precursor, an IR laser irradiating device and a layout computer. Pattern information is directly transferred from the layout computer to the laser device.

After the pattern information has been written in the heat-sensitive mask layer (C), the entire surface of the flexographic printing plate precursor is irradiated with active light rays via the imagewise-mask (main exposure). This process may be carried out with the plate attached to the laser cylinder; however, a method is generally used in which, after the plate has been removed from the laser device, the irradiation process is carried out by using a commonly-used irradiation unit having a flat plate shape because this method is more advantageous in that even a plate size out of the standard can be appropriately handled. Examples of the active light rays include: ultraviolet rays having an emission peak at a wavelength in a range from 330 to 380 nm. Examples of its light source include: a low-pressure mercury lamp, a highpressure mercury lamp, a super-high pressure mercury lamp, a metal halide lamp, a xenon lamp, a zirconium lamp, a carbon arc lamp and an ultraviolet-ray fluorescent lamp. Thereafter, the irradiated plate is developed, subjected to finishing exposure, and subjected to exposure with a germicidal lamp whereby the printing plate is obtained. The development step can be performed with a conventional development unit.

In a flexographic printing plate prepared as above, when fine dots each having a diameter of 16 $\mu$m are formed at 175 lines per 2.54 cm (lpi) on the printing plate, the dots do not buckle until a load of 0.2 N is applied thereto, preferably until a load of 0.3 N is applied thereto, more preferably until a load of 0.5 N is applied thereto, and further preferably until a load of 1.0 N is applied thereto. The flexographic printing plate according to the present invention has these characteristic properties. Therefore, fine dots on the printing plate do not buckle in an actual printing procedure, and consequently the excessive print growth of the fine dots by the printing procedure can be prevented in a fade-out part. When the fine dots buckle, an ink may be transferred onto an object to be printed not only from the dot convex parts but also from dot side parts. As a result, very large dot gain may be formed.

In the present invention, the measurement as to how much load can be applied to a dot until the dot buckles was performed by determining a minimum load at which buckling was observed (i.e., buckling load). More specifically, the measurement was performed by the following method.

As to the buckling measurement device, TMA Q400 manufactured by TA Instruments Japan Inc. was used. A probe having a contact diameter of 0.89 mm was inserted into a dot at a load speed of 0.5 N/min., and a compression degree (a deformation degree) of the dot was measured. An inflection point in the dot deformation was defined as a buckling load. The amount of a preload was 0.01 N, the retention time before the measurement was 1 minute, and a maximum load was 1 N. The dots to be used for the measurement were dots each having a diameter of 16 $\mu$m which were formed at 175 lines per 2.54 cm (lpi) and were located on a piece cut in a size of 4 mm square. The cut printed plate was stored under an environment having a temperature of 25°C and a humidity of 65% RH for 24 hours, and then was subjected to the measurement. The measurement was performed 5 times, and an average of the measurement values was determined.

Also, in a flexographic printing plate prepared as above, when fine dots each having a diameter of 16 $\mu$m are formed at 175 lines per 2.54 cm (lpi) on the printing plate, the shoulder angle of each dot is 105 to 125°, preferably 110 to 120°. If the shoulder angle is less than the above-mentioned range, the fine dots are apt to buckle and the fine dots in a fade-out part are apt to undergo excessive print growth. If the shoulder angle is more than the above-mentioned range, excessive dot filling is apt to occur in a shadow part.

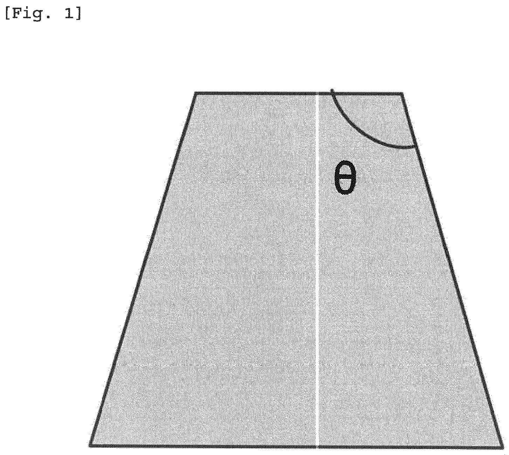

In the present invention, as to a device for measuring a shoulder angle of a dot, a color 3D laser microscope VK-9700 (manufactured by Keyence Corporation) was used. The objective lens to be used was one having a magnification of x50, and the measurement pitch was 0.5 $\mu$m. The position shown in FIG. 1 which shows a longitudinal cross-section of a dot was defined as a shoulder angle of the dot. Dots each having a diameter of 16 $\mu$m and formed at 175 lines per 2.54 cm (lpi) were measured.

Furthermore, in a flexographic printing plate prepared as above, when fine dots each having a diameter of 16 $\mu$m are formed at 175 lines per 2.54 cm (lpi) on the printing plate, the dot depth is 70 to 85 $\mu$m, preferably 72 to 83 $\mu$m. If the dot depth is less than the above-mentioned range, the fine dots are apt to buckle and the fine dots in a fade-out part are apt to undergo excessive print growth. If the dot depth is more than the above-mentioned range, excessive dot filling is apt to occur in a shadow part.

In the present invention, as to a device for measuring a dot depth, a color 3D laser microscope VK-9700 (manufactured by Keyence Corporation) was used. The objective lens to be used was one having a magnification of x50, and the measurement pitch was 0.5 $\mu$m. The distance between a dot top and a dot bottom was defined as a dot depth. Dots each having a diameter of 16 $\mu$m and formed at 175 lines per 2.54 cm (lpi) were measured.

A printing plate to be used in the measurement of the above-mentioned buckling load, shoulder angle of a dot, and dot depth was produced under the following conditions. Back exposure, main exposure and finishing exposure were performed using TL-K 40W/10R lamp (peak wavelength: 370 nm, luminance at 350 nm: 10 mW/cm$^2$) manufactured by Philips. As to the germicidal lamp, a germicidal lamp GL-40 (peak wavelength: 250 nm, luminance at 250 nm: 4.5 mW/cm$^2$) manufactured by Panasonic Corporation. The imaging of the heat-sensitive mask layer was performed using CDI 4850 manufactured by ESCO Graphics at a resolution of 4000 dots per 2.54 cm (dpi). An image to be evaluated was one having at least dots (at 175 lines per 2.54 cm (lpi), 0 to 10%) formed in 0.3% increment and dot gradation parts (fade-out parts) where the dot gradation shifts to zero. The amount of back exposure was adjusted to a time at which the relief depth could become 0.6 mm. The amount of main exposure was adjusted to a time at which 1% dots (diameter: 16 $\mu$m) was reproduced on the printing plate. After a development step and a subsequent drying step were performed, finishing exposure was performed for 7 minutes, and finally the plate was irradiated with a germicidal lamp for 5 minutes so as to prepare a printing plate.

In a flexographic printing plate prepared as above, the composite elastic modulus of each dot can be 30 to 80 MPa, preferably 35 to 75 MPa, and more preferably 40 to 70 MPa. Due to this composite elastic modulus of each dot, the flexographic printing plate of the present invention can achieve the reduction in dot gain of fine dots in the fade-out part.

The composite elastic modulus mentioned in the present invention was measured under the following measurement conditions using a nanoindentation device (Hysitron TI Premier) manufactured by Bruker. The calibration of the device was performed using quartz. The measurement was performed under the conditions where the value within the range of 69.6 $\pm$ 5% GPa can be obtained.

Indenter: a berkovich-type diamond indenter
Tip opening angle: 142.3°

Maximum Indentation depth: 4500 nm
Load speed, unload speed: 4500 nm/sec
Retention time: 0 sec
Feedback Mode: Displ. Control

The dynamic hardness measurement device DUH-201 which is used in Patent Document 1 has a minimum testing force of 100 μN, while TI Premier has a minimum testing force of 75 nN. Therefore, TI Premier enables a highly accurate measurement. Due to this difference in stress sensing accuracy, TI Premier enables a highly accurate measurement compared with the measurement device used in Patent Document 1.

A printing plate to be used in the measurement of a composite elastic modulus was produced under the following conditions. Back exposure, main exposure and finishing exposure were performed using TL-K 40W/10R lamp (peak wavelength: 370 nm, luminance at 350 nm: 10 mW/cm$^2$) manufactured by Philips. As to the germicidal lamp, a germicidal lamp GL-40 (peak wavelength: 250 nm, luminance at 250 nm: 4.5 mW/cm$^2$) manufactured by Panasonic Corporation. The imaging of the heat-sensitive mask layer was performed using CDI 4850 manufactured by ESCO Graphics at a resolution of 4000 dots per 2.54 cm (dpi). An image to be evaluated was one having at least dots (at 175 lines per 2.54 cm (lpi), 0 to 10%) formed in 0.3% increments and dot gradation parts (fade-out parts) where the dot gradation shifts to zero. The amount of back exposure was adjusted to a time at which the relief depth could become 0.6 mm. The amount of main exposure was adjusted to a time at which 1% dots (diameter: 16 μm) was reproduced on the printing plate. After a development step and a subsequent drying step were performed, finishing exposure was performed for 7 minutes, and finally the plate was irradiated with a germicidal lamp for 5 minutes so as to prepare a printing plate.

A portion in which the diameter of each of dots was 25 μm was cut out from the printing plate produced under the above-mentioned printing plate production conditions, and was subjected to the measurement of a composite elastic modulus of each dot. The piece cut out from the printing plate was stored under the conditions of 25°C and 65% RH for 24 hours, and subsequently was subjected to the measurement of a composite elastic modulus. First, the position of an indenter was adjusted in such a manner that the indenter fell down at the center of each dot, then the indenter is pushed into a specimen, and a load-deflection curve was determined. The composite elastic modulus of each dot was calculated from the load-deflection curve in accordance with the following equation. In the equation, Er represents a composite elastic modulus, S represents contact stiffness, and Ac represents a contact area. In the fitting curve, the lower fit was set to 20%, and the upper fit was set to 95%. The measurement was performed 50 times, and an average of the measurement values was determined. The composite elastic modulus of each solid-printed part was determined by cutting out a solid-printed part from the printing plate produced under the above-mentioned printing plate production conditions, and was measured under the same measurement conditions as those employed for the measurement of the composite elastic modulus of each dot.

$$\texttt{Composite elastic modulus Er = S}\sqrt{\pi}/2\sqrt{\texttt{Ac}}$$

As shown in the equation, a composite elastic modulus is a parameter which also considers elastic deformation. In contrast, dynamic hardness which has been employed as an evaluation parameter of hardness in the prior art techniques is a parameter which does not consider elastic deformation.

In addition, from the viewpoint of measurement accuracy, a composite elastic modulus has an advantage that a further highly accurate measurement becomes possible compared with dynamic hardness, as explained above. This difference is caused from the difference in stress sensing accuracy of the devices used for these parameters.

Examples

As hereunder, the effects of the flexographic printing plate of the present invention will be illustrated by referring to the following Examples although the present invention is not limited to those Examples. A term "part(s)" in Examples stand(s) for part(s) by mass. Values shown in Tables which indicate a composition ratio also stand for part(s) by mass.

Evaluation in Examples was done in accordance with the following methods.

(1) Buckling load of dot

As to the measurement device, TMA Q400 manufactured by TA Instruments Japan Inc. was used. A probe having a contact diameter of 0.89 mm was inserted into a dot at a load speed of 0.5 N/min., and a compression degree (a deformation degree) of the dot was measured. An inflection point in the dot deformation was defined as a buckling load. The amount of a preload was 0.01 N, the retention time before the measurement was 1 minute, and a maximum load was 1 N. The dots to be used for the measurement were dots each having a diameter of 16 μm which were formed at 175 lines per 2.54 cm (lpi) and were located on a piece cut in a size of 4 mm square.

(2) Shoulder angle of dot

As to the measurement device, a color 3D laser microscope VK-9700 (manufactured by Keyence Corporation) was used. The objective lens to be used was one having a magnification of x50, and the measurement pitch was 0.5 $\mu$m. The position shown in FIG. 1 which shows a longitudinal cross-section of a dot was defined as a shoulder angle of the dot. Dots each having a diameter of 16 $\mu$m and formed at 175 lines per 2.54 cm (lpi) were measured. The measurement was performed 5 times, and an average of the measurement values was determined.

(3) Dot depth

As to the measurement device, a color 3D laser microscope VK-9700 (manufactured by Keyence Corporation) was used. The objective lens to be used was one having a magnification of x50, and the measurement pitch was 0.5 $\mu$m. The distance between a dot top and a dot bottom was defined as a dot depth. Dots each having a diameter of 16 $\mu$m and formed at 175 lines per 2.54 cm (lpi) were measured. The measurement was performed 5 times, and an average of the measurement values was determined.

(4) Composite elastic modulus of dot

Using the flexographic printing plate produced in Example 1, a composite elastic modulus of each dot was calculated by the above-mentioned method using Hysitron TI Premier, manufactured by Bruker.

(5) Printability in fade-out part

Regarding the flexographic printing plate produced in Example 1, dot gain in fade-out part was evaluated using a flexographic printing machine FPR302 (manufactured by MCK Corporation) and using Anilox of 900LPI. As to the ink, an UV ink (product name: FLEXOCURE CYAN (manufactured by Flint)) was used. As to an object to be printed, coat paper (product name: Pearl Coat (manufactured by Oji Paper Co., Ltd.)) was used. The printing speed was 50 m/min. A position in which the printing plate contacted with the object to be printed was defined as zero. The indentation depth in printing was determined as a position at which the indenter was pushed into a depth of 90 $\mu$m from the zero position. The printed dot sizes on the most-end part in each fade-out part on the printed matter were measured. A dot having a dot print area of less than 700 $\mu$m$^2$ was rated as "∞", a dot having a dot print area of 700 $\mu$m$^2$ or more and less than 1200 $\mu$m$^2$ exclusive was rated as "o", and a dot having a dot print area of 1200 $\mu$m$^2$ or more and less than 1800 $\mu$m$^2$ was rated as "Δ", and a dot having a dot print area of 1800 $\mu$m$^2$ or more was rated as "×". A smaller numerical value for a dot print area means that the printability in a fade-out part is superior.

(6) Reproducibility of isolated dot

The reproducibility of a minimum isolated dot on the printing plate was measured. A minimum isolated dot having a size of 50 $\mu$m or less was rated as "oo", a minimum isolated dot having a size of larger than 50 $\mu$m and not larger than 100 $\mu$m was rated as "o", a minimum isolated dot having a size of larger than 100 $\mu$m and not larger than 200 $\mu$m was rated as "Δ", and a minimum isolated dot having a size of larger than 200 $\mu$m was rated as "×". A smaller size of the reproduced minimum isolated dot means that the reproducibility of an isolated dot was superior.

(7) Durability of printing plate

Regarding the flexographic printing plate produced in Example 1, durability of printing plate was evaluated using a flexographic printing machine FPR302 (manufactured by MCK Corporation) and using Anilox of 900LPI. As to the ink, an UV ink (product name: FLEXOCURE CYAN (manufactured by Flint)) was used. As to an object to be printed, coat paper (product name: Pearl Coat (manufactured by Oji Paper Co., Ltd.)) was used. The printing speed was 50 m/min. A position in which the printing plate contacted with the object to be printed was defined as zero. The indentation depth in printing was determined as a position at which the indenter was pushed into a depth of 150 $\mu$m from the zero position. By such a printing method, the flexographic printing plate produced in Example 1 was subjected to printing at a length of 5,000 m. Dots each having a diameter of 16 $\mu$m on the plate after the printing were observed with a microscope. A dot of which the appearance was not changed before and after the printing was rated as "oo", a dot which was slightly abraded only at an edge part was rated as "o", a dot which was partially lack or abraded was rated as "Δ", and a dot which was entirely lack or abraded was rated as "×".

Example 1

Preparation of photosensitive resin composition

A butadiene latex (Nipol LX111NF, non-volatile content: 55%, manufactured by Zeon Corporation) (86 parts by mass) that served as the polymer prepared by polymerizing a conjugated diene, an acrylonitrile-butadiene latex (Nipol SX1503, non-volatile content: 42%, manufactured by Zeon Corporation) (24 parts by mass) that served as the polymer prepared by polymerizing a conjugated diene, a polybutadiene-terminal acrylate having a number average molecular weight of 10000 (BAC45, manufactured by Osaka Organic Chemical Industry Ltd.) (15 parts by mass) that served as an ethylenically unsaturated compound, trimethylolpropane trimethacrylate having a number average molecular weight of 338 (Light Ester TMP, manufactured by Kyoeisha Chemical Co., Ltd.) (10 parts by mass) that served as ethylenically unsaturated compound, benzyl dimethylketal (3 parts by mass) that served as a photopolymerization initiator, and a hydrophilic polymer (PFT-4, non-volatile content: 25%, manufactured by Kyoeisha Chemical Co., Ltd.) (20 parts by mass), a butadiene oligomer (B2000, manufactured by Nippon Soda Co., Ltd.) (9.9 parts by mass), a thermal stabilizer (4-methoxyphenol) (0.1 part by mass), and an ultraviolet ray absorber (Tinuvin 326) (0.01 part by mass) that served as auxiliary components were mixed together in a container so as to produce a dope. The dope was charged into a pressurized kneader, and then the solvent was removed under a reduced pressure at 80°C so as to produce a photosensitive resin composition.

Preparation of flexographic printing plate precursor

Carbon black dispersion (AMBK-8 manufactured by ORIENT CHEMICAL INDUSTRIES CO., LTD.), copolymerized polyamide (PA223 manufactured by TOYOBO CO., LTD.), propylene glycol, and methanol were mixed at a mass proportion of 45/5/5/45 so as to obtain a heat-sensitive mask layer coating solution. After a releasing treatment was performed on both sides of a PET film (E5000 manufactured by TOYOBO CO., LTD., thickness: 100 $\mu$m), the heat-sensitive mask layer coating solution was applied onto the PET film using a bar coater so that a thickness of a coating film after being dried was 2 $\mu$m, and dried at 120°C for 5 minutes so as to obtain a film laminate (I). An optical density thereof was 2.3. The optical density was measured using a black-and-white transmission densitometer DM-520 (SCREEN Holdings Co., Ltd.). Polyvinyl acetate (KH20 manufactured by NIHON GOSEI KAKO Co., Ltd.) having a saponification degree of 80% and a plasticizer (glycerin) were mixed at a mass proportion of 70/30 so as to obtain an oxygen barrier layer coating solution. The oxygen barrier layer coating solution was applied onto the film laminate (I) using a bar coater so that a thickness of a coating film after being dried was 2.0 $\mu$m, and dried at 120°C for 5 minutes so as to obtain a film laminate (II). The photosensitive resin composition was disposed on a PET film support (E5000 manufactured by TOYOBO CO., LTD., thickness: 125 $\mu$m) coated with a copolymerized polyester-based adhesive, and the film laminate (II) was superposed on the photosensitive resin composition. These were laminated at 100°C using a heat pressing machine so as to obtain a flexographic printing plate precursor including a PET support, an adhesive layer, a photosensitive resin layer, an oxygen barrier layer, a heat-sensitive mask layer, and a cover film. A total thickness of the plate was 1.14 mm.

Preparation of printing plate from flexographic printing plate precursor

The printing plate precursor was subjected to back exposure from the PET support side for 10 seconds. Subsequently, the cover film was peeled off. This plate was wound around CDI4530 (manufactured by ESCO Graphics), and was then subjected to abrasion at a resolution of 4000 dots per 2.54 cm (dpi) using a test image having dots (at 175 lines per 2.54 cm (lpi), 0 to 10%, in 0.3% increment), isolated dots (between 0 to 300 $\mu$m, in 50 $\mu$m increment), and dot gradation parts (fade-out parts) where the dot gradation shifts to zero. After the ablation, the plate was taken out, returned to the plane shape, and subjected to main exposure for 7 minutes. Thereafter, development was performed for 8 minutes using a developing machine (Stuck System, 1% aqueous washing soap solution, 40°C) manufactured by A & V Co., Ltd., and water droplets on the plate surface were removed with a drain stick. Thereafter, the plate was dried in a dryer at 60°C for 10 minutes, subjected to finishing exposure for 7 minutes, and finally irradiated with light from a germicidal lamp for 5 minutes, whereby a flexographic printing plate was thus obtained. The back exposure, main exposure and finishing exposure were performed using TL-K 40W/10R lamp (peak wavelength: 370 nm, luminance at 350 nm: 10 mW/cm$^2$) manufactured by Philips. As to the germicidal lamp, a germicidal lamp GL-40 (peak wavelength: 250 nm, luminance at 250 nm: 4.5 mW/cm$^2$) manufactured by Panasonic Corporation was used. It was confirmed that the relief depth of the resultant printing plate was 0.6 mm and dots each having a diameter of 16 $\mu$m were reproduced on the printing plate.

(Examples 2 to 15 and Comparative Examples 1 to 3)

Flexographic printing plate precursors were prepared in the same manner as in Example 1 except that the composition ratio of each component in the photosensitive resin composition constituting the photosensitive resin layer was changed as presented in Tables 1 and 2. The time of back exposure was adjusted so that the relief depth became 0.6 mm, and the time of main exposure was adjusted to a time at which dots each having a diameter of 16 $\mu$m were reproduced on the printing plate.

Evaluation results of Examples 1 to 15 and Comparative Examples 1 to 3 are shown in Tables 1 and 2. Examples 7 and 8 are Examples in accordance with the present invention while Examples 1 to 6 and 9 to 15 are Reference Examples not in accordance with the present invention.

[Table 1]

| | | | Examples | | | | |
|---|---|---|---|---|---|---|---|
| | | | 1 | 2 | 3 | 4 | 5 |
| Components of photosensitive resin layer (% by mass) | polymer prepared by polymerizing conjugated diene | butadiene polymer (LX111 NF) | 47 | 43 | 43 | 47.5 | 44 |
| | | NBR polymer (SX1503A) | 10 | 10 | 7 | 10 | 10 |
| | ethylenically unsaturated compound | (meth)acrylate having low molecular weight (Light Ester TMP) | 10 | 10 | 13 | 10 | 13 |
| | | (meth)acrylate having low molecular weight (Light Ester 1,6 HX) | | | | | |
| | | (meth)acrylate having low molecular weight (Light Ester 19ND) | | | | | |
| | | acrylate having high molecular weight (BAC45) | 15 | 15 | 15 | 15 | 15 |
| | | (meth)acrylate having high molecular weight (TE2000) | | | | | |
| | photopolymerization initiator | benzyl dimethylketal | 3 | 5 | 7 | 2.5 | 3 |
| | | benzophenone | | | | | |
| | hydrophilic polymer | PFT4 | 5 | 5 | 5 | 5 | 5 |
| | plasticizer | butadiene oligomer (B2000) | 9.9 | 9.9 | 9.9 | 9.9 | 9.9 |
| | thermal polymerization inhibitor | 4-methoxyphenol | 0.1 | 0.1 | 0.1 | 0.1 | 0.1 |
| | ultraviolet ray absorber | Tinuvin 326 | 0.01 | 0.01 | 0.01 | 0.01 | 0.01 |
| Ratio of amount of photopolymerization initiator / (meth)acrylate having low molecular weight | | | 0.30 | 0.50 | 0.54 | 0.25 | 0.23 |
| Oxygen barrier layer | | | present | present | present | present | present |

(continued)

| Properties of dot | | | Examples | | | | |
|---|---|---|---|---|---|---|---|
| | | | 1 | 2 | 3 | 4 | 5 |
| Properties of dot | | buckling load of dot (N) | 0.29 | 0.32 | absent | 0.25 | 0.31 |
| | | shoulder angle of dot (°) | 110 | 115 | 120 | 108 | 111 |
| | | dot depth (μm) | 80 | 77 | 71 | 82 | 78 |
| | | composite elastic modulus of dot (Mpa) | 45 | 60 | 70 | 35 | 48 |
| Evaluation results | | printability in a fade-out part | ○ (900) | ○ (700) | ○○ (600) | ○ (1000) | ○ (800) |
| | | reproducibility of isolated dot | ○ (100) | ○ (100) | ○ (100) | ○ (100) | ○ (100) |
| | | durability of printing plate | ○ | ○ | ○ | ○ | ○ |

| | | | Examples | | | | |
|---|---|---|---|---|---|---|---|
| | | | 6 | 7 | 8 | 9 | 10 |
| Components of photosensitive resin layer (% by mass) | polymer prepared by polymerizing conjugated diene | butadiene polymer (LX111 NF) | 50 | 46.8 | 46.6 | 44 | 50 |
| | | NBR polymer (SX1503A) | 10 | 10 | 10 | 8 | 12 |
| | ethylenically unsaturated compound | (meth)acrylate having low molecular weight (Light Ester TMP) | 7 | 10 | 10 | 10 | 10 |
| | | (meth)acrylate having low molecular weight (Light Ester 1,6 HX) | | | | | |
| | | (meth)acrylate having low molecular weight (Light Ester 19ND) | | | | | |
| | | acrylate having high molecular weight (BAC45) | 15 | 15 | 15 | 20 | 10 |
| | | (meth)acrylate having high molecular weight (TE2000) | | | | | |
| | photopolymerization initiator | benzyl dimethylketal | 3 | 3 | 3 | 3 | 3 |
| | | benzophenone | | 0.2 | 0.4 | | |
| | hydrophilic polymer | PFT4 | 5 | 5 | 5 | 5 | 5 |

(continued)

|  |  |  | Examples | | | | |
|---|---|---|---|---|---|---|---|
|  |  |  | 6 | 7 | 8 | 9 | 10 |
|  | plasticizer | butadiene oligomer (B2000) | 9.9 | 9.9 | 9.9 | 9.9 | 9.9 |
|  | thermal polymerization inhibitor | 4-methoxyphenol | 0.1 | 0.1 | 0.1 | 0.1 | 0.1 |
|  | ultraviolet ray absorber | Tinuvin 326 | 0.01 | 0.01 | 0.01 | 0.01 | 0.01 |
| Ratio of amount of photopolymerization initiator / (meth)acrylate having low molecular weight | | | 0.43 | 0.32 | 0.34 | 0.30 | 0.30 |
| Oxygen barrier layer | | | present | present | present | present | present |
| Properties of dot | buckling load of dot (N) | | 0.28 | 0.29 | 0.29 | 0.3 | 0.28 |
|  | shoulder angle of dot (°) | | 109 | 110 | 110 | 111 | 106 |
|  | dot depth ($\mu$m) | | 82 | 80 | 80 | 78 | 82 |
|  | composite elastic modulus of dot (Mpa) | | 40 | 50 | 55 | 47 | 43 |
| Evaluation results | printability in a fade-out part | | ○ (900) | ○ (700) | ○○ (600) | ○ (800) | ○ (1000) |
|  | reproducibility of isolated dot | | ○ (100) | ○ (100) | ○ (100) | ○○ (50) | Δ (150) |
|  | durability of printing plate | | ○ | ○ | ○ | ○○ | Δ |

|  |  |  | Examples | | | | |
|---|---|---|---|---|---|---|---|
|  |  |  | 11 | 12 | 13 | 14 | 15 |
|  | polymer prepared by polymerizing conjugated diene | butadiene polymer (LX111 NF) | 47 | 47 | 47 | 59 | 47 |
|  |  | NBR polymer (SX1503A) | 10 | 10 | 10 | 13 | 10 |

(continued)

| | | | Examples | | | | |
|---|---|---|---|---|---|---|---|
| | | | 11 | 12 | 13 | 14 | 15 |
| Components of photosensitive resin layer (% by mass) | ethylenically unsaturated compound | (meth)acrylate having low molecular weight (Light Ester TMP) | | | 10 | 10 | 10 |
| | | (meth)acrylate having low molecular weight (Light Ester 1,6 HX) | 10 | | | | |
| | | (meth)acrylate having low molecular weight (Light Ester 19ND) | | 10 | | | |
| | | acrylate having high molecular weight (BAC45) | 15 | 15 | | 0 | 15 |
| | | (meth)acrylate having high molecular weight (TE2000) | | | 15 | 0 | |
| | photopolymerization initiator | benzyl dimethylketal | 3 | 3 | 3 | 3 | 3 |
| | | benzophenone | | | | | |
| | hydrophilic polymer | PFT4 | 5 | 5 | 5 | 5 | 5 |
| | plasticizer | butadiene oligomer (B2000) | 9.9 | 9.9 | 9.9 | 9.9 | 9.9 |
| | thermal polymerization inhibitor | 4-methoxyphenol | 0.1 | 0.1 | 0.1 | 0.1 | 0.1 |
| | ultraviolet ray absorber | Tinuvin 326 | 0.01 | 0.01 | 0.01 | 0.01 | 0.01 |
| Ratio of amount of photopolymerization initiator / (meth)acrylate having low molecular weight | | | 0.30 | 0.30 | 0.30 | 0.30 | 0.30 |
| Oxygen barrier layer | | | present | present | present | present | absent |
| Properties of dot | | buckling load of dot (N) | 0.29 | 0.27 | 0.29 | 0.27 | 0.23 |
| | | shoulder angle of dot (°) | 110 | 109 | 110 | 108 | 106 |
| | | dot depth ($\mu$m) | 80 | 81 | 80 | 82 | 84 |
| | | composite elastic modulus of dot (Mpa) | 45 | 42 | 45 | 40 | 32 |

(continued)

| | | Examples | | | | |
|---|---|---|---|---|---|---|
| | | 11 | 12 | 13 | 14 | 15 |
| Evaluation results | printability in a fade-out part | ○ (900) | ○ (1000) | ○ (900) | ○ (1100) | Δ (1200) |
| | reproducibility of isolated dot | ○ (100) | ○ (100) | ○ (100) | Δ (200) | ○ (100) |
| | durability of printing plate | ○ | ○ | ○ | Δ | ○ |

[Table 2]

| | | | Comparative Examples | | |
|---|---|---|---|---|---|
| | | | 1 | 2 | 3 |
| Components of photosensitive resin layer (% by mass) | polymer prepared by polymerizing conjugated diene | butadiene polymer (LX111NF) | 49 | 50.5 | 52 |
| | | NBR polymer (SX1503A) | 10 | 12 | 12 |
| | ethylenically unsaturated compound | (meth)acrylate having low molecular weight (Light Ester TMP) | 10 | 6 | 3 |
| | | (meth)acrylate having low molecular weight (Light Ester 1,6 HX) | | | |
| | | (meth)acrylate having low molecular weight (Light Ester 19ND) | | | |
| | | acrylate having high molecular weight (BAC45) | 15 | 15 | 15 |
| | | (meth)acrylate having high molecular weight (TE2000) | | | |
| | photopolymerization initiator | benzyl dimethylketal | 1 | 1.5 | 3 |
| | | benzophenone | | | |
| | hydrophilic polymer | PFT4 | 5 | 5 | 5 |
| | plasticizer | butadiene oligomer (B2000) | 9.9 | 9.9 | 9.9 |
| | thermal polymerization inhibitor | 4-methoxyphenol | 0.1 | 0.1 | 0.1 |
| | ultraviolet ray absorber | Tinuvin 326 | 0.01 | 0.01 | 0.01 |
| Ratio of amount of photopolymerization initiator / (meth)acrylate having low molecular weight | | | 0.10 | 0.25 | 1.00 |
| Oxygen barrier layer | | | present | present | present |
| Properties of dot | | buckling load of dot (N) | 0.14 | 0.17 | 0.18 |
| | | shoulder angle of dot (°) | 102 | 103 | 103 |
| | | dot depth (μm) | 87 | 86 | 86 |
| | | composite elastic modulus of dot (Mpa) | 20 | 16 | 25 |

(continued)

| | | Comparative Examples | | |
|---|---|---|---|---|
| | | 1 | 2 | 3 |
| Evaluation results | printability in a fade-out part | × (2100) | × (1900) | × (1800) |
| | reproducibility of isolated dot | ○ (100) | ○ (100) | ○ (100) |
| | durability of printing plate | ○ | ○ | ○ |

Details of the ethylenically unsaturated compound in the above Tables are as follows.

Light Ester TMP: Trimethylolpropane tri(meth)acrylate, number average molecular weight: 338, manufactured by Kyoeisha Chemical Co., Ltd.
Light Ester 1,6 HX: 1,6-hexanediol dimethacrylate, number average molecular weight: 254, manufactured by Kyoeisha Chemical Co., Ltd.
Light Ester 19ND: 1,9-nonanediol di (meth)acrylate, number average molecular weight: 298, manufactured by Kyoeisha Chemical Co., Ltd.
BAC45: Polybutadiene-terminal acrylate, number average molecular weight: 10000, manufactured by Osaka Organic Chemical Industry Ltd.
TE2000: Polybutadiene having a methacrylate group introduced at terminal thereof, urethane-bonded type, number average molecular weight: 3,000, manufactured by Nippon Soda Co., Ltd.

As apparent from the evaluation results shown in Tables 1 and 2, in Examples 1 to 15 in which the buckling load, the shoulder angles and the depths of the fine dots respectively fell within the ranges defined herein, the printability in a fade-out part was excellent. As to the method for adjusting each of the buckling load, the shoulder angles and the depths of the fine dots respectively to a value within the range defined herein, it is critical that: the photopolymerization initiator is added in a larger amount compared with the conventional flexographic printing plate; a (meth)acrylate compound having a low molecular weight is added in a specified amount; and the ratio of the amount of the photopolymerization initiator to the amount of the (meth) acrylate compound having a low molecular weight is adjusted to a value within a specified range. In addition, by further adding a (meth)acrylate compound having a high molecular weight, even when the photopolymerization initiator is added in a larger amount, the reproducibility of isolated dots and the durability of a printing plate are not deteriorated (see the comparison between Examples 1 to 8, 11 to 13, and 15 with Examples 9, 10, and 14). Furthermore, by using benzophenone in combination with the photopolymerization initiator, the composite elastic modulus of each dot can be increased (see the comparison between Examples 1 to 6 and 9 to 15 with Examples 7 and 8). Furthermore, by providing an oxygen barrier layer, the printability of fine dots in a fade-out part can be further improved (see the comparison between Examples 1 to 14 with Example 15).

In contrast, in Comparative Example 1, because the amount of the photopolymerization initiator added was small which was the same amount level as that employed conventionally, each of the buckling load, the shoulder angles and the depths of the fine dots was out of the range defined herein. Accordingly, Comparative Example 1 was inferior in the printability in a fade-out part. In Comparative Example 2, because the amount of the photopolymerization initiator added was small, even when the ratio of the amount of the photopolymerization initiator to the amount of the (meth)acrylate compound having a low molecular weight was proper, each of the buckling load, the shoulder angles and the depths of the fine dots was out of the range defined herein. Accordingly, Comparative Example 2 was inferior in the printability in a fade-out part. In Comparative Example 3, because the amount of the (meth)acrylate compound having a low molecular weight added was small, each of the buckling load, the shoulder angles and the depths of the fine dots was out of the range defined herein. Accordingly, Comparative Example 3 was inferior in the printability in a fade-out part.

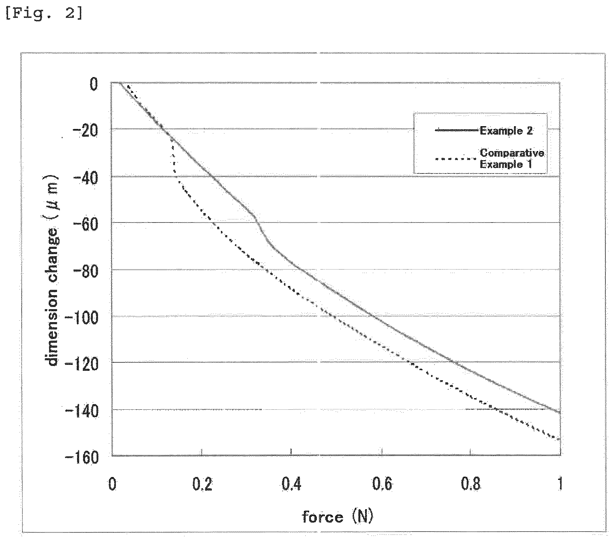

For reference, the results of the measurement of buckling loads in Example 2 and Comparative Example 1 are shown in FIG. 2. As apparent from the graphs shown in FIG. 2, the fine dots buckled at 0.32 N in Example 2, while the fine dots buckled at 0.14 N in Comparative Example 1.

Industrial Applicability

In the flexographic printing plate according to the present invention, the buckling load of fine dots are adjusted to a specific higher value. Therefore, the dot gain of the fine dots can be reduced not only in a center part of an image but also in a fade-out part of the image, resulting in the improvement in printing quality of the fine dots in the fade-out part. Therefore, the flexographic printing plate of the present invention is very useful in the industrial field.

## Claims

**1.** A flexographic printing plate obtained from a flexographic printing plate precursor comprising at least a support (A), a photosensitive resin layer (B) and a heat-sensitive mask layer (C) which are laminated in this order, **characterized in that**, when dots each having a diameter of 16 $\mu$m are formed at 175 lines per 2.54 cm (lpi) on the printing plate, the dots do not buckle until a load of 0.2 N is applied thereto, as measured in accordance with the method set out in the description,

wherein a photosensitive resin composition constituting the photosensitive resin layer (B) comprises (a) a polymer prepared by polymerizing a conjugated diene, (b) an ethylenically unsaturated compound and (c) a photopolymerization initiator, and wherein the content of the photopolymerization initiator (c) in the photosensitive resin composition is 2 to 9% by mass based on the total mass of the photosensitive resin composition, wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass based on the total mass of the photosensitive resin composition, and wherein the ratio of the mass of the photopolymerization initiator (c) and the mass of the (meth)acrylate compound (i) having a number average molecular weight of 100 to 600 in the photosensitive resin composition is within the range of 0.20 to 0.55, wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass based on the total mass of the photosensitive resin composition, and wherein the photopolymerization initiator (c) includes two types of compounds which are a benzyl alkyl ketal compound and a benzophenone compound, and wherein the ratio of the mass of the benzyl alkyl ketal compound to the mass of the benzophenone compound is within the range of 99:1 to 80:20.

**2.** The flexographic printing plate according to claim 1, wherein, when dots each having a diameter of 16 $\mu$m are formed at 175 lines per 2.54 cm (lpi) on the printing plate, the shoulder angle of each dot is 105 to 125°, as measured in accordance with the method set out in the description.

**3.** The flexographic printing plate according to claim 1 or 2, wherein, when dots each having a diameter of 16 $\mu$m are formed at 175 lines per 2.54 cm (lpi) on the printing plate, the dot depth is 70 to 85 $\mu$m, as measured in accordance with the method set out in the description.

**4.** The flexographic printing plate according to any of claims 1 to 3, wherein the flexographic printing plate precursor has an oxygen barrier layer (D) between the photosensitive resin layer (B) and the heat-sensitive mask layer (C).

**5.** The flexographic printing plate according to any of claims 1 to 4, wherein the flexographic printing plate has been obtained by developing the flexographic printing plate precursor using a water-based developing solution.

**6.** A flexographic printing method, **characterized in that** the method uses the flexographic printing plate according to any of claims 1 to 5.

## Patentansprüche

**1.** Flexodruckplatte, erhalten aus einem Flexodruckplattenvorläufer, umfassend wenigstens einen Träger (A), eine lichtempfindliche Harzschicht (B) und eine wärmeempfindliche Maskenschicht (C), welche in dieser Reihenfolge laminiert sind, **dadurch gekennzeichnet, dass**, wenn Punkte jeweils mit einem Durchmesser von 16 um bei 175 Linien pro 2,54 cm (lpi) auf der Druckplatte gebildet sind, die Punkte erst bei Anlegen einer Last von 0,2 N, gemessen in Übereinstimmung mit dem in der Beschreibung angegebenen Verfahren, nachgeben,

wobei eine lichtempfindliche Harzzusammensetzung, welche die lichtempfindliche Harzschicht (B) ausmacht, (a) ein Polymer, hergestellt durch Polymerisieren eines konjugierten Diens, (b) eine ethylenisch ungesättigte Verbindung und (c) einen Photopolymerisationsinitiator umfasst, und wobei der Gehalt des Photopolymerisationsinitiators (c) in der lichtempfindlichen Harzzusammensetzung 2 bis 9 Masse-%, bezogen auf die Gesamtmasse der lichtempfindlichen Harzzusammensetzung, beträgt,

wobei die ethylenisch ungesättigte Verbindung (b) eine (Meth)acrylatverbindung (i) mit einem zahlengemittelten Molekulargewicht von 100 bis 600 einschließt, wobei der Gehalt der (Meth)acrylatverbindung (i) mit einem zahlengemittelten Molekulargewicht von 100 bis 600 in der lichtempfindlichen Harzzusammensetzung 5 bis 16 Masse-%, bezogen auf die Gesamtmasse der lichtempfindlichen Harzzusammensetzung, beträgt, und wobei das Verhältnis der Masse des Photopolymerisationsinitiators (c) zu der Masse der (Meth)acrylatverbindung (i) mit einem zahlengemittelten Molekulargewicht von 100 bis 600 in der lichtempfindlichen Harzzusammensetzung im Bereich von 0,20 bis 0,55 liegt,

wobei die ethylenisch ungesättigte Verbindung (b) weiter eine (Meth)acrylatverbindung (ii) mit einem zahlengemittelten Molekulargewicht von mehr als 600 und nicht mehr als 20000 einschließt, und wobei der Gehalt der (Meth)acrylatverbindung (ii) mit einem zahlengemittelten Molekulargewicht von mehr als 600 und nicht mehr als 20000 in der lichtempfindlichen Harzzusammensetzung 5 bis 25 Masse-%, bezogen auf die Gesamtmasse der lichtempfindlichen Harzzusammensetzung, beträgt, und

wobei der Photopolymerisationsinitiator (c) zwei Arten von Verbindungen, welche eine Benzylalkylketalverbindung und eine Benzophenonverbindung sind, einschließt, und wobei das Verhältnis der Masse der Benzylalkylketalverbindung zu der Masse der Benzophenonverbindung im Bereich von 99:1 bis 80:20 liegt.

2. Flexodruckplatte nach Anspruch 1, wobei, wenn Punkte jeweils mit einem Durchmesser von 16 μm bei 175 Linien pro 2,54 cm (lpi) auf der Druckplatte gebildet sind, der Schulterwinkel jedes Punktes 105 bis 125°, gemessen in Übereinstimmung mit dem in der Beschreibung angegebenen Verfahren, beträgt.

3. Flexodruckplatte nach Anspruch 1 oder 2, wobei, wenn Punkte jeweils mit einem Durchmesser von 16 μm bei 175 Linien pro 2,54 cm (lpi) auf der Druckplatte gebildet sind, die Punkttiefe 70 bis 85 μm, gemessen in Übereinstimmung mit dem in der Beschreibung angegebenen Verfahren, beträgt.

4. Flexodruckplatte nach einem der Ansprüche 1 bis 3, wobei der Flexodruckplattenvorläufer eine Sauerstoffsperrschicht (D) zwischen der lichtempfindlichen Harzschicht (B) und der wärmeempfindlichen Maskenschicht (C) aufweist.

5. Flexodruckplatte nach einem der Ansprüche 1 bis 4, wobei die Flexodruckplatte durch Entwickeln des Flexodruckplattenvorläufers unter Verwendung einer Entwicklerlösung auf Wasserbasis erhalten worden ist.

6. Flexodruckverfahren, **dadurch gekennzeichnet, dass** das Verfahren die Flexodruckplatte nach einem der Ansprüche 1 bis 5 verwendet.

**Revendications**

1. Plaque d'impression flexographique obtenue à partir d'un précurseur de plaque d'impression flexographique comprenant au moins un support (A), une couche de résine photosensible (B) et une couche de masque thermosensible (C) qui sont stratifiés dans cet ordre, **caractérisée en ce que**, lorsque des points ayant chacun un diamètre de 16 μm sont formés à 175 lignes pour 2,54 cm (lpi) sur la plaque d'impression, les points ne se gondolent pas jusqu'à ce qu'une charge de 0,2 N leur soit appliquée, telle que mesurée conformément au procédé établi dans la description,

dans laquelle une composition de résine photosensible constituant la couche de résine photosensible (B) comprend (a) un polymère préparé en polymérisant un diène conjugué, (b) un composé à insaturation éthylénique et (c) un initiateur de photopolymérisation, et dans laquelle la teneur en l'initiateur de photopolymérisation (c) dans la composition de résine photosensible est de 2 à 9 % en masse, basée sur la masse totale de la composition de résine photosensible,

dans laquelle le composé à insaturation éthylénique (b) inclut un composé de (méth)acrylate (i) ayant un poids moléculaire moyen en nombre de 100 à 600, dans laquelle la teneur en le composé de (méth)acrylate (i) ayant un poids moléculaire moyen en nombre de 100 à 600 dans la composition de résine photosensible est de 5 à 16 % en masse basée sur la masse totale de la composition de résine photosensible, et dans laquelle le rapport de la masse de l'initiateur de photopolymérisation (c) et la masse du composé de (méth)acrylate (i) ayant un poids moléculaire moyen en nombre de 100 à 600 dans la composition de résine photosensible est au sein de la plage de 0,20 à 0,55,

dans laquelle le composé à insaturation éthylénique (b) inclut en outre un composé de (méth)acrylate (ii) ayant un poids moléculaire moyen en nombre de plus de 600 et pas plus de 20 000, et dans laquelle la teneur en le composé de (méth)acrylate (i) ayant un poids moléculaire moyen en nombre de plus de 600 et pas plus de 20 000 dans la composition de résine photosensible est de 5 à 25 % en masse basée sur la masse totale de la composition de résine photosensible, et

dans laquelle l'initiateur de photopolymérisation (c) inclut deux types de composés qui sont un composé de benzylalkylcétal et un composé de benzophénone, et dans laquelle le rapport de la masse du composé de benzylalkylcétal sur la masse du composé de benzophénone est au sein de la plage de 99/1 à 80/20.

2. Plaque d'impression flexographique selon la revendication 1, dans laquelle lorsque des points ayant chacun un diamètre de 16 μm sont formés à 175 lignes pour 2,54 cm (lpi) sur la plaque d'impression, l'angle d'épaule de chaque point est de 105 à 125°, tel que mesuré conformément au procédé établi dans la description.

3. Plaque d'impression flexographique selon la revendication 1 ou 2, dans laquelle lorsque des points ayant chacun un diamètre de 16 μm sont formés à 175 lignes pour 2,54 cm (lpi) sur la plaque d'impression, la profondeur de point est de 70 à 85 μm, telle que mesurée conformément au procédé établi dans la description,

4. Plaque d'impression flexographique selon l'une quelconque des revendications 1 à 3, dans laquelle le précurseur de plaque d'impression flexographique a une couche barrière à l'oxygène (D) entre la couche de résine photosensible (B) et la couche de masque thermosensible (C).

5. Plaque d'impression flexographique selon l'une quelconque des revendications 1 à 4, dans laquelle la plaque d'impression flexographique a été obtenue en développant le précurseur de plaque d'impression flexographique en utilisant une solution de développement à base d'eau.

6. Procédé d'impression flexographique, **caractérisé en ce que** le procédé utilise la plaque d'impression flexographique selon l'une quelconque des revendications 1 à 5.

[Fig. 1]

[Fig. 2]

**EP 4 019 253 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0980743 A
- JP 6395920 B
- JP 6079625 B
- JP 2001005173 A
- JP 2019095470 A
- JP 2018091953 A
- WO 2016174948 A1
- US 2019061406 A1
- US 2004259034 A1
- JP 4200510 B
- JP 5710961 B
- JP 5525074 B